# EUROPEAN PATENT SPECIFICATION

(11) **EP 4 233 176 B1**
(45) Date of publication and mention of the grant of the patent: **10.06.2026**
(21) Application number: 21794574.0
(22) Date of filing: 19.10.2021
(51) Int. Cl.: H04N 25/78

(54) **COMPARATOR, ANALOG-TO-DIGITAL CONVERTER, SOLID-STATE IMAGING DEVICE, CAMERA SYSTEM, AND ELECTRONIC APPARATUS**
KOMPARATOR, ANALOG-DIGITAL-WANDLER, FESTKÖRPERBILDGEBUNGSVORRICHTUNG, KAMERASYSTEM UND ELEKTRONISCHE VORRICHTUNG
COMPARATEUR, CONVERTISSEUR ANALOGIQUE-NUMÉRIQUE, DISPOSITIF D'IMAGERIE À SEMI-CONDUCTEURS, SYSTÈME DE CAMÉRA ET APPAREIL ÉLECTRONIQUE

(30) Priority: 20.10.2020 EP 20202869
(43) Date of publication of application: 30.08.2023
(73) Proprietor: Sony Semiconductor Solutions Corporation, Atsugi-shi, Kanagawa 243-0014 (JP); Sony Europe B.V., Weybridge, Surrey KT13 0XW (GB)
(72) Inventor: SAMADPOOR RIKAN, Behnam, 70327 Stuttgart (DE); KAWAZU, Naoki, 70327 Stuttgart (DE)
(74) Representative: Müller Hoffmann & Partner
(86) International application number: PCT/EP2021/078993
(87) International publication number: WO 2022/084342

(56) References cited:
- EP-A1- 3 493 407
- US-A1- 2015 187 335
- US-A1- 2018 288 345

## Description

### TECHNICAL FIELD

The present disclosure relates to a comparator, an analog-to-digital converter, a solid-state imaging device, and a camera system.

### BACKGROUND

In recent years, CMOS (complementary metal-oxide semiconductor) image sensors have received attention as alternative for CCDs (charge coupled devices).

In manufacturing a CMOS image sensor, it is possible to use the same manufacturing process as that of a common CMOS integrated circuit. In addition, it is possible to drive the CMOS image sensor with a single power supply. Moreover, it is possible to mix together an analog circuit and a logic circuit using a CMOS process in the same chip. Therefore, the CMOS image sensor brings some advantages such as a reduction in the number of peripheral integrated circuits.

The CMOS image sensor includes one FD (Floating Diffusion) amplifier for each pixel. The pixels are arranged in an array of pixels along rows and columns. For outputting the pixel output signal the CMOS image sensor selects one of the rows of the pixel array and simultaneously reads out all pixels in the selected row in a column direction.

As a general method of eliminating noise, CDS (Correlated Double Sampling) has been known. In this method, a signal level in a state immediately before its sampling (reset level) is once read and stored, and then a signal level after the sampling is read and subtracted from the reset level to eliminate the noise.

The pixel signal reading (outputting) circuit of the column-parallel output CMOS image sensor typically includes an analog-to-digital converter (hereinafter referred to as an ADC) for each column. The ADC converts the analogue pixel output signal into a digital pixel signal.

Document US 2018/0288345 describes an image sensor that includes a pixel array with pixel rows and pixel columns, a vertical scanner, ADCs for each pixel column, a horizontal transfer unit and a reference voltage generator. A control unit controls the vertical scanner, the horizontal transfer unit, and the reference voltage generator to implement a correlated double sampling technique, wherein the ADCs compare the signal levels of pixel signals with a ramped reference signal generated by the reference voltage generator. Each ADC includes a comparator unit with a differential stage for comparing the signal levels of the pixel signal and the ramped reference signal in D phases and P phases of a double sampling cycle. The control unit controls the differential stage in such a way that a current through the differential stage is higher in a D phase comparison period and a P phase comparison period than outside the comparison periods, wherein the control unit permanently checks whether the image sensor is in a D phase or a P phase. Control signals generated by one global control unit control the bias current for the differential stage in each ADC.

Document US 2015/187335 A1 describes a CMOS image sensor that includes a pixel array portion with pixel rows and pixel columns, a row scanning unit and a column processing unit. The column processing unit includes AD conversion circuits with comparator circuits for comparing pixel signals with a ramp-like reference signal. Each comparator circuit includes a differential circuit unit, a current supply unit and a control unit. The control unit detects an operation timing of the differential circuit unit and outputs a control signal that controls the current which is supplied to the differential circuit unit according to a detection result thereof. The output signal of the differential circuit unit is supplied to a first amplifier supplying the output voltage Vout and to a second amplifier supplying the control signal for the current. The second amplifier is electrically directly connected in parallel to the first amplifier. By properly selecting the thresholds for the first and second amplifiers and for a certain waveform for the ramp-like reference signal, the rising slope of the control signal output at the second amplifier follows the corresponding slope of the output voltage Vout at a temporal distance that depends on the slope of the ramp-like reference signal. The second amplifier is directly electrically connected parallel to the first amplifier.

Document EP 3 493 407 A1 refers to a CMOS image sensor with an ADC comparing an electrical signal obtained from a pixel (pixel signal) with a variable-level reference signal and subjecting the pixel signal to AD conversion by using the result of the comparison between the pixel signal and the reference signal. The ADC performs correlated double sampling to obtain digital pixel values from the pixel signal. The reference signal includes the P-phase and the D-phase during which the reference signal changes ("slope-containing sections"). Each ADC includes a comparator with a differential pair for comparing the signal levels of the pixel signal and the slope-containing sections of the reference signal. A control section controls the bias current for the differential stage in response to the reference signal supplied to the input of the comparator.

The "background" description provided herein is for the purpose of generally presenting the context of the disclosure. Work of the presently named inventors, to the extent it is described in this background section, as well as aspects of the description which may not otherwise qualify as prior art at the time of filing, are neither expressly or impliedly admitted as prior art against the present invention.

### SUMMARY

Today, solid-state imaging devices are increasingly integrated in a multitude of battery-powered application systems, e.g. electric vehicles, in which low power consumption of the solid-state imaging device is of high interest.

The present disclosure has been made in view of the above circumstances, and it is therefore desirable to provide a comparator, an analog-to-digital converter, a solid-state imaging device, and a camera system with low power consumption.

According to a first embodiment a comparator includes a differential pair with a first transistor and a second transistor. The first transistor includes a first control input. The second transistor includes a second control input. A common node is electrically connected to the first transistor and the second transistor. An output node is electrically connected to the differential pair. A tail current circuit is electrically connected to the common node. The tail current circuit includes a tail current control input. The tail current circuit is configured to supply a first tail current to the differential pair in a first mode and a second tail current in a second mode. The tail current circuit is also configured to switch between the first mode and the second mode in response to a control signal applied to the tail current control input.

According to a second embodiment an analog-to-digital converter includes a digital-to-analog converter and an auxiliary circuit.

The digital-to-analog converter includes a control input and an analog output, wherein the analog output is electrically coupled to the first control input or to the second control input of the differential pair. An auxiliary control circuit is electrically connected to the control input of the digital-to-analog converter and to the tail current control input of the tail current circuit. The auxiliary circuit is configured to provide a synchronized change of a first digital control signal applied to the control input of the digital-to-analog converter and the tail current control signal applied to the tail current control input.

According to a third embodiment a solid-state imaging device includes a pixel array unit and an analog-to-digital converter. The pixel array unit includes a plurality of pixel circuits arranged in matrix form, wherein the pixel circuits are configured to perform photoelectric conversion. The analog-to-digital converter is configured to convert an electric signal corresponding to a charge obtained by the photoelectric conversion in a pixel circuit into a digital pixel signal. The analog-to-digital converter includes a digital-to-analog converter and a comparator. The digital-to-analog converter is configured to output a reference voltage ramp at an analog output. The comparator is configured to compare the electric signal obtained from a pixel circuit with the reference voltage ramp output at the analog output of the analog-to-digital converter. The comparator is further configured to generate a digital comparator output signal indicating a result of the comparison. The comparator includes a differential pair with a first transistor and a second transistor. The first transistor includes a first control input. The second transistor includes a second control input. A common node is electrically connected to the first transistor and the second transistor. An output node is electrically connected to the differential pair. A tail current circuit is electrically connected to the common node. The tail current circuit includes a tail current control input. The tail current circuit is configured to supply a first tail current to the differential pair in a first mode and a second tail current in a second mode. The tail current circuit is also configured to switch between the first mode and the second mode in response to a tail current control signal applied to the tail current control input.

According to a fourth embodiment a camera system includes a solid-state imaging device and an optical system configured to form a subject image on the solid-sate imaging device. The solid-state imaging device includes a pixel array unit and an analog-to-digital converter. The pixel array unit includes a plurality of pixel circuits arranged in matrix form, wherein the pixel circuits are configured to perform photoelectric conversion. The analog-to-digital converter is configured to convert an electric signal corresponding to a charge obtained by the photoelectric conversion in a pixel circuit into a digital pixel signal. The analog-to-digital converter includes a digital-to-analog converter and a comparator. The digital-to-analog converter is configured to output a reference voltage ramp at an analog output. The comparator is configured to compare the electric signal obtained from a pixel circuit with the reference voltage ramp output at the analog output of the analog-to-digital converter. The comparator is further configured to generate a digital comparator output signal indicating a result of the comparison. The comparator includes a differential pair with a first transistor and a second transistor. The first transistor includes a first control input. The second transistor includes a second control input. A common node is electrically connected to the first transistor and the second transistor. An output node is electrically connected to the differential pair. A tail current circuit is electrically connected to the common node. The tail current circuit includes a tail current control input. The tail current circuit is configured to supply a first tail current to the differential pair in a first mode and a second tail current in a second mode. The tail current circuit is also configured to switch between the first mode and the second mode in response to a tail current control signal applied to the tail current control input.

The foregoing paragraphs have been provided by way of general introduction, and are not intended to limit the scope of the following claims. The described embodiments, together with further advantages, will be best understood by reference to the following detailed description taken in conjunction with the accompanying drawings.

The scope of the present invention is defined according to the embodiments of the appended independent claim. Specific embodiments are defined by the dependent claims.

### BRIEF DESCRIPTION OF THE DRAWINGS

A more complete appreciation of the disclosure and many of the attendant advantages thereof will be readily obtained as the same becomes better understood by reference to the following detailed description when considered in connection with the accompanying drawings, wherein:
FIG. 1 is a block diagram illustrating an embodiment of an image sensor assembly of a solid-state imaging device according to an embodiment of the present technology.
FIG. 2 is a circuit diagram illustrating a configuration example of a pixel circuit disposed in a pixel array unit of the image sensor assembly of FIG. 1.
FIG. 3 is a diagram illustrating driving timings of the pixel circuit illustrated in FIG. 2.
FIG. 4 is a block diagram illustrating a configuration example of an analog-to-digital converter.
FIG. 5 is a diagram illustrating driving timings of the analog-to-digital converter of FIG. 4.
FIG. 6 is a block diagram of a comparator with switchable tail current circuit according to an embodiment of the present technology.
FIG. 7 is a diagram illustrating signal timings at the comparator of FIG. 6 for a dark pixel signal.
FIG. 8 is a diagram illustrating signal timings at the comparator of FIG. 6 for a bright pixel signal.
FIG. 9 is a diagram illustrating signal timings at a comparative converter circuit without switchable tail current circuit for a dark pixel signal.
FIG. 10 is a diagram illustrating signal timings at a comparative converter circuit without switchable tail current circuit for a bright pixel signal.
FIG. 11 is a circuit diagram of another comparator with switchable tail current circuit according to a further embodiment of the present technology.
FIG. 12 is a circuit diagram of another comparator with switchable tail current circuit and delay circuit for the comparator output signal according to a further embodiment of the present technology.
FIG. 13 is a diagram illustrating signal timings concerning the delay circuit of FIG. 12.
FIG. 14 is a diagram illustrating signal timings at the comparator of FIG. 12 for a dark pixel signal.
FIG. 15 is a diagram illustrating signal timings at the comparator of FIG. 12 for a bright pixel signal.
FIG. 16 is a circuit diagram of an analog-to-digital converter with a comparator including an auxiliary control circuit according to a further embodiment.
FIG. 17 is a diagram showing an example of the laminated structure of a solid-state imaging device according to an embodiment of the present disclosure.
FIG. 18 illustrates an overview of a configuration example of a multi-layer solid-state imaging device to which a technology according to the present disclosure may be applied.
FIG. 19 is a block diagram depicting an example of a schematic configuration of an in-vivo information acquisition system.
FIG. 20 is a block diagram depicting an example of a schematic configuration of a vehicle control system.
FIG. 21 is a diagram of assistance in explaining an example of installation positions of an outside-vehicle information detecting section and an imaging section of the vehicle control system of FIG. 20.

### DETAILED DESCRIPTION

Referring now to the drawings, wherein like reference numerals designate identical or corresponding parts throughout the several views. In the following, a technology for reducing the power consumption of comparators is described in the context of CMOS image sensors. The technology may also be used for other types of sensors using a comparator in combination with a voltage ramp output by a digital-to-analogue converter for digitalizing an analog sensor signal.

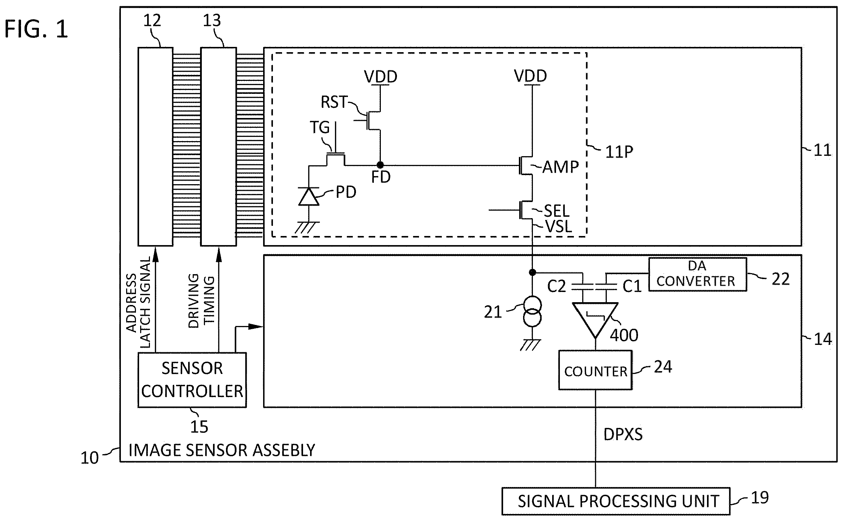

FIG. 1 illustrates a configuration example of an image sensor assembly 10 according to an embodiment of the present technology.

The image sensor assembly 10 includes a pixel array unit 11, an address decoder 12, a pixel timing driving unit 13, an ADC (analog-to-digital converter) 14, and a sensor controller 15.

The pixel array unit 11 includes a plurality of pixel circuits 11P arranged matrix-like in rows and columns. Each pixel circuit 11P includes a photosensitive element and FETs (field effect transistors) for controlling the signal output by the photosensitive element.

The address decoder 12 and the pixel timing driving unit 13 control driving of each pixel circuit 11P disposed in the pixel array unit 11. That is, the address decoder 12 supplies a control signal for designating the pixel circuit 11P to be driven or the like to the pixel timing driving unit 13 according to an address, a latch signal, and the like supplied from the sensor controller 15. The pixel timing driving unit 13 drives the FETs of the pixel circuit 11P according to driving timing signals supplied from the sensor controller 15 and the control signal supplied from the address decoder 12. The electric signals of the pixel circuits 11P (pixel output signals) are supplied through vertical signal lines VSL to ADCs 14, wherein each ADC 14 is connected to one of the vertical signal lines VSL, and wherein each vertical signal line VSL is connected to all pixel circuits 11P of one column of the pixel array unit 11. Each ADC 14 performs an analog-to-digital conversion on the pixel output signals successively output from the column of the pixel array unit 11 and outputs the digital pixel signals DPXS to the signal processing unit 19. To this purpose, each ADC 14 includes a comparator 400, a digital-to-analog converter (DAC) 22 and a counter 24.

The sensor controller 15 controls the entire image sensor assembly 10. That is, for example, the sensor controller 15 supplies the address and the latch signal to the address decoder 12, and supplies the driving timing signal to the pixel timing driving unit 13. In addition, the sensor controller 15 may supply a control signal for controlling the ADC 14. Among the configuration elements of the image sensor assembly 10 described above, the present technology relates to the ADC 14, in particular to the comparator 400 of the ADC 14.

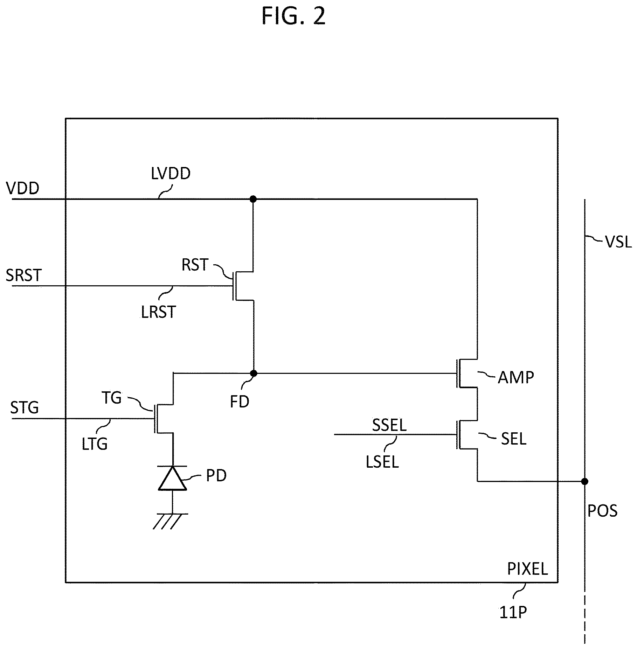

FIG. 2 is a diagram showing an example of a pixel circuit 11P including four FETs.

The pixel circuit 11P includes a photoelectric conversion element PD as the photosensitive element. The photoelectric conversion element PD may include or may be composed of, for example, a photodiode. With respect to one photoelectric conversion element PD, the pixel circuit 11P has four FETs serving as active elements, i.e., a transfer transistor TG, a reset transistor RST, an amplification transistor AMP, and a selection transistor SEL.

The photoelectric conversion element PD photoelectrically converts incident light into electric charges (here, electrons). The amount of electric charge generated in the photoelectric conversion element PD corresponds to the amount of the incident light.

The transfer transistor TG is connected between the photoelectric conversion element PD and a floating diffusion region FD. The transfer transistor TG serves as a transfer element for transferring charge from the photoelectric conversion element PD to the floating diffusion region FD. The floating diffusion region FD serves as temporary local charge storage. A transfer signal STG serving as a control signal is supplied to the gate (transfer gate) of the transfer transistor TG through a transfer control line LTG.

Thus, the transfer transistor TG may transfer electrons photoelectrically converted by the photoelectric conversion element PD to the floating diffusion FD.

The reset transistor RST is connected between the floating diffusion FD and a power supply line LVDD to which a positive supply voltage VDD is supplied. A reset signal SRST serving as a control signal is supplied to the gate of the reset transistor RST through a reset control line LRST.

Thus, the reset transistor RST serving as a reset element resets a potential of the floating diffusion FD to that of the power supply line LVDD.

The floating diffusion FD is connected to the gate of the amplification transistor AMP serving as an amplification element. That is, the floating diffusion FD functions as the input node of the amplification transistor AMP serving as an amplification element.

The amplification transistor AMP and the selection transistor SEL are connected in series between the power supply line LVDD and a vertical signal line VSL.

Thus, the amplification transistor AMP is connected to the signal line VSL through the selection transistor SEL and constitutes a source-follower circuit with a constant current source 21 outside the pixel circuit 11P and illustrated in FIG. 1.

Then, a selection signal SSEL serving as a control signal corresponding to an address signal is supplied to the gate of the selection transistor SEL through the selection control line LSEL, and the selection transistor SEL is turned on.

When the selection transistor SEL is turned on, the amplification transistor AMP amplifies the potential of the floating diffusion FD and outputs a voltage corresponding to the potential of the floating diffusion FD to the signal line VSL. The signal line VSL transfers the pixel output signal POS from the pixel circuit 11P to the ADC 14 illustrated in FIG. 1.

Since the respective gates of the transfer transistor TG, the reset transistor RST, and the selection transistor SEL are, for example, connected in units of rows, these operations are simultaneously performed for each of the pixel circuits 11P of one row.

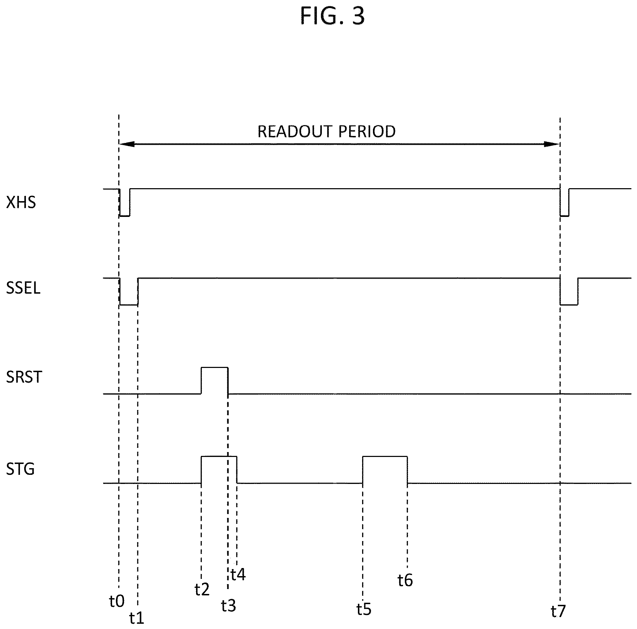

FIG. 3 shows on/off timings of the selection signal SSEL, the reset signal SRST, and the transfer signal STG of the pixel circuit 11P of FIG. 2 within a single readout period of a horizontal synchronization signal XHS.

At t=t0 the readout period for reading out the pixel circuits of one horizontal row of the pixel array unit may start with a negative voltage pulse of the horizontal synchronization signal XHS. The readout period ends at t=t7. Synchronously with the horizontal synchronization signal XHS, the selection signal SSEL may change from the high level to the low level.

At t=t1 the selection signal SSEL gets active high level. The selection transistor turns on and connects the pixel circuit 11P with the vertical signal line VSL.

Between t=t2 and t=t3, a positive pulse of the reset signal SRST turns the reset transistor RST on. The reset transistor RST connects the floating diffusion region FD to the positive supply voltage VDD. At the same time a positive pulse of the transfer signal STG may turn on the transfer transistor TG to connect the photoelectric conversion element PD with the floating diffusion region FD such that both the floating diffusion region FD and the photoelectric conversion element PD are set to a defined potential.

The reset transistor RST may be switched off at t=t3 to disconnect the floating diffusion region FD from the positive supply voltage VDD. The transfer transistor TG may be switched off at t=t4 to disconnect the photoelectric conversion element PD from the floating diffusion region FD.

Between t=t4 and t=t5 the potential of the floating diffusion region FD represents a current (momentary) offset charge of the unilluminated pixel circuit 11P. The offset charge may be, inter alia, a measure for the momentary noise in the pixel circuit 11P.

The ADC 14 may measure a pixel offset voltage corresponding to the offset charge in a P phase (preset phase) of the readout period. The signal processing unit 19 illustrated in FIG. 1 may temporary store a digital voltage value of the current pixel offset voltage.

Starting from t=t4 the photoelectric conversion element PD may start accumulating electric charge. Between t=t5 and t=t6 a positive signal pulse of the transfer signal STG is applied to the gate of the transfer transistor TG. The transfer transistor TG turns on and connects the photoelectric conversion element PD and the floating diffusion region FD, wherein charge accumulated in the photoelectric conversion element PD is transferred to the floating diffusion region. The charge transfer ends at t=t6 with the transfer transistor TG being switched off.

After t=t6 the electric signal applied to the vertical signal line VSL corresponds to the amount of charge transferred from the photoelectric conversion element PD to the floating diffusion region FD and is a measure for the amount of incident light. The electric signal applied to the vertical signal line VSL by the pixel circuit 11P is referred to as pixel output signal POS in the following.

The ADC 14 may measure the potential applied to the vertical signal line VSL in a D phase (data phase) of the readout period. The signal processing unit 19 illustrated in FIG. 1 may use the digital voltage value of the pixel offset voltage obtained in the P-phase to correct the pixel output voltage obtained in the D-phase.

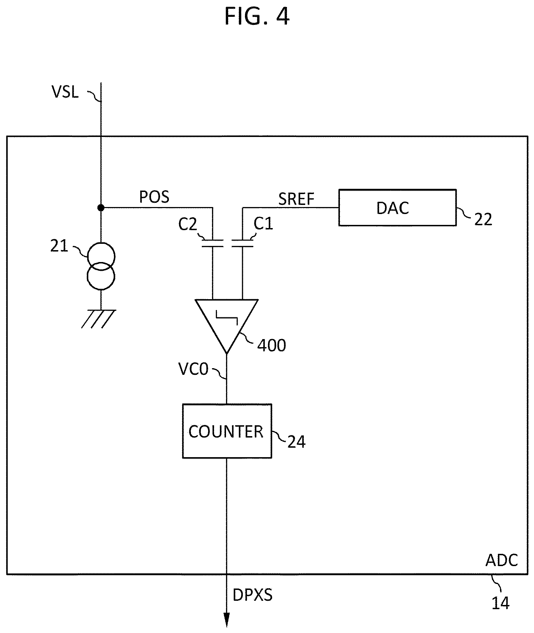

Next, FIG. 4 illustrates a configuration example of the ADC 14 that performs analog-to-digital conversion on the pixel output signal transmitted through the vertical signal line VSL from the pixel circuit 11P of FIG. 3 to the ADC 14. The ADC 14 may include a DAC 22, the constant current source 21 connected to the vertical signal line VSL, a comparator 400, and a counter 24.

The vertical signal line VSL, the constant current source 21 and the amplifier transistor AMP of the pixel circuit 11P of FIG. 3 combine to a source follower circuit.

The DAC 22 generates and outputs a reference signal SREF. By performing digital-to-analog conversion of a digital signal increased in regular intervals, e.g. by one, the DAC 22 may generate a reference signal including a reference voltage ramp. Within the voltage ramp, the reference signal steadily increases per time unit. The increase may be linear or not linear.

The comparator 400 has two input terminals. The reference signal SREF output from the DAC 22 is supplied to a first input terminal of the comparator 400 through a first capacitor C1. The pixel output signal POS transmitted through the vertical signal line VSL is supplied to the second input terminal of the comparator 400 through a second capacitor C2.

The comparator 400 compares the pixel output signal POS and the reference signal SREF that are supplied to the two input terminals with each other, and outputs a comparator output signal VCO representing the comparison result. That is, the comparator 400 outputs the comparator output signal VCO representing the magnitude relationship between the pixel output signal POS and the reference signal SREF. For example, the comparator output signal VCO may have high level when the pixel output signal POS is higher than the reference signal SREF and may have low level otherwise, or vice versa. The comparator output signal VCO is supplied to the counter 24.

The counter 24 counts a count value in synchronization with a predetermined clock. That is, the counter 24 starts the count of the count value from the start of the P phase or the D phase when the DAC 22 starts to decrease the reference signal SREF, and counts the count value until the magnitude relationship between the pixel output signal POS and the reference signal SREF changes and the comparator output signal VCO is inverted. When the comparator output signal VCO is inverted, the counter 24 stops the count of the count value and outputs the count value at that time as the AD conversion result (digital pixel data DPXS) of the pixel output signal POS.

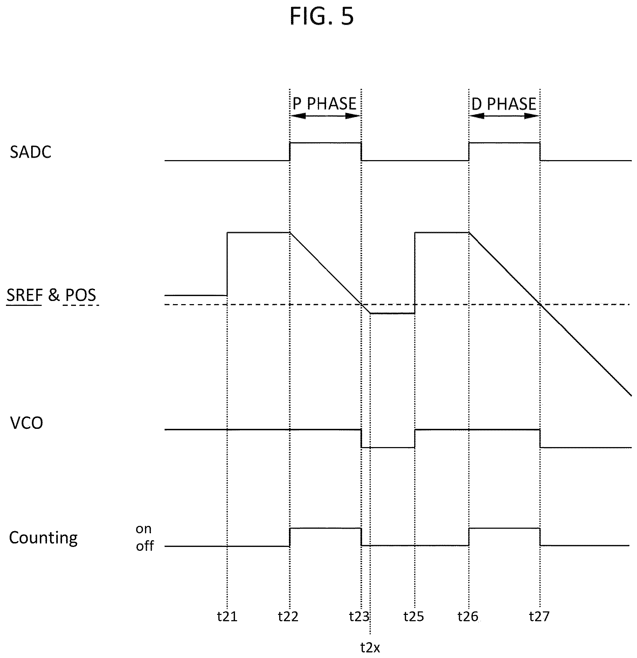

The diagram in FIG. 5 refers to a readout period of the pixel circuit 11P of FIG. 2. The readout period may include a P phase (preset phase) for reading the pixel offset voltage contained in the pixel output signal POS and a D phase (date phase) for reading the pixel output voltage in the pixel output signal POS. In the CDS (correlated double sampling) method the D phase follows the P phase. In the DDS (double data sampling) method the P phase follows the D phase. The examples of the present technique, in particular the comparator 400 can be combined with each of the CDS reading cycle and the DDS reading cycle. In the following, reference is made to the CDS reading cycle for illustrative purpose.

The diagram shows an ADC control signal SADC, a combined representation of the reference signal SREF as continuous line and a pixel output signal POS of a dark pixel as broken line, the comparator output signal VCO and the state of the counter 24 of FIG. 4.

Prior to the end of the reset pulse, e.g. prior to the start of the reset pulse, the reference signal SREF output by the DAC 22 of FIG. 4 may change from the low level to the high level at t=t21. The high level may correspond to a totally dark signal.

At t=t22 a change of the ADC control signal SADC from the low level to the high level may start the P phase of the CDS reading cycle by synchronously starting the reference voltage ramp output by the DAC 22 and the counter 24.

Once started, the DAC 22 steadily decreases the level of the reference signal SREF with time. The reduction may be linear with time or non-linear with time.

In the P phase of the CDS reading cycle, in a case in which the magnitude relationship between the reference signal SREF and the pixel output signal POS is inverted with respect to the start of the P phase, the comparator output signal VCO of the comparator 400 is inverted, thereby changing, e.g., from the high level to the low level as illustrated for t=t23.

In the meantime, beginning from the start of the P phase, the counter 24 steadily increases a count value and ends the count of the count value when the comparator output signal VCO is inverted at t=t23. The count value at t=t23 is the P phase data and corresponds to a pixel offset voltage representative for the momentary noise in the pixel circuit.

As described above, the ADC 14 of FIG. 4 obtains the count value by counting the time required for the change of the reference signal SREF until the pixel output signal POS matches the reference signal SREF according to the comparator output VCO. The count value gives the analog-to-digital conversion result of the voltage of the pixel output signal POS.

After the end of the P phase, the decrease of the reference signal SREF may continue until t=t2x. At t=t25 the reference signal SREF is increased again to the voltage level at the start of the P phase. Synchronously, the comparator output signal VCO changes again to the high level.

Thereafter, the transfer transistor is turned on for a predetermined time period and the charge of the photoelectric conversion element is transferred to and accumulated in the floating diffusion region. The pixel output voltage POS decreases by a voltage amount determined by the electric charge in the floating diffusion region.

Since the photoelectric conversion element accumulates electrons (negative electrical charge), the pixel output voltage POS gets more negative when it detects high illuminance (bright case) as compared with the case it detects low illuminance (dark case).

Since FIG. 5 refers to an unilluminated pixel (dark pixel). the photoelectric conversion device accumulates no electric charge and the level of the pixel output signal POS shows no change.

At t=t26 the ADC control signal SADC starts the D phase of the CDS reading cycle by synchronously starting both the DAC 22 and the counter 24 of FIG. 4. The reference signal SREF again starts decreasing.

In the D phase of the CDS reading cycle, in a case in which the magnitude relationship between the reference signal SREF and the pixel output signal POS is inverted with respect to the start of the D phase, the comparator output signal VCO of the comparator 400 is inverted, for example, from the high level to the low level at t=t27.

The counter 24 starts the count of the count value from the start of the D phase and ends the count of the count value when the comparator output signal VCO is inverted. The count value at this time is the D phase data and represents a digital pixel value of the pixel output voltage. The digital pixel value may be corrected on the basis of the digital value of the pixel offset voltage obtained as result of the P phase.

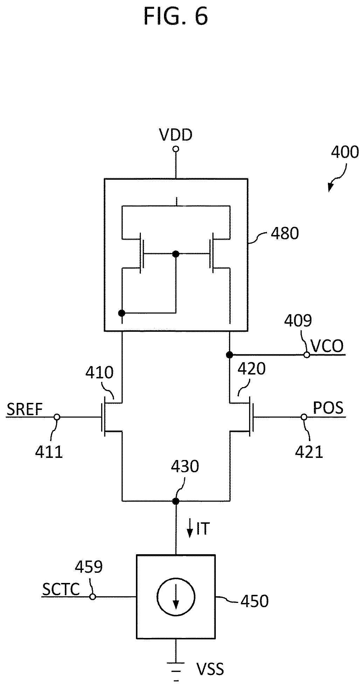

FIG. 6 shows details of the comparator 400 shown in FIGS. 1 and 4. The comparator 400 includes a differential pair 410, 420 of matching transistors. In particular, the differential pair includes a first transistor 410 with a first control input 411 and a second transistor 420 with a second control input 421.

The first and second transistors 410, 420 may be n-FETs, by way of example. The source of the first transistor 410 and the source of the second transistor 420 are electrically connected to a common node 430.

The drain of the first transistor 410 and the drain of the second transistor 420 may be electrically connected to a collector circuit 480. The collector circuit 480 may include a first drain resistor connected between a positive voltage supply VDD and the drain of the first transistor 410 and may include a second drain resistor connected between the positive voltage supply VDD and the drain of the second transistor 420. Alternatively, the collector circuit 480 may include a current-mirror connected to the positive supply voltage VDD.

An output node 409 of the comparator 400 is electrically connected to the differential pair 410, 420. The output node 409 may be connected to the drain of one of the first and second transistors 410, 420, e.g. to the drain of the second transistor 420. At the output node 409 the comparator 400 outputs a digital, e.g. binary comparator output signal VCO. The comparator output signal VCO indicates a result of a comparison of a first input signal applied to the first control input 411 and a second input signal applied to the second control input 421.

For example, the comparator output signal VCO may have a high voltage level, when the level of the first input signal applied to the first control input 411 has a higher voltage level than a second input signal applied to the second control input 421 and may have a low voltage level, when the level of the first input signal has a lower voltage level than the second input signal, or vice versa.

A tail current circuit 450 is electrically connected between the common node 430 and the negative supply voltage VSS. The tail current circuit 450 may include a current source controllable through a tail current control signal SCTC applied to a tail current control input 459 of the tail current circuit 450.

Depending on a voltage level of the tail current control signal SCTC, the tail current circuit 450 switches between a first mode of operation and a second mode of operation. In the first mode, the tail current circuit 450 supplies a first tail current to the differential pair 410, 420. In the second mode the tail current circuit 450 supplies a second tail current.

The first tail current and the second tail current differ in amperage (current intensity), wherein the second tail current (low tail current) is lower than the first tail current (high tail current). The first tail current may be in a range from 1µA to 100µA, e.g. in a range from 5µA to 20µA. For example, the first tail current is or approximates 10µA. The second tail current may be at most 80% or at most 50% of the first tail current. For example, the second tail current may be at most 20% of the first tail current or may be zero or approximately zero.

The precision of a comparator increases with increasing tail current. Therefore, comparators are usually operated with that tail current that just delivers the required accuracy.

By contrast, the comparator 400 of FIG. 6 can take advantage from that high precision is only required during certain time sub-periods of the readout period. Accordingly, the tail current is switched to high tail current only for the certain time periods in which high precision is needed, whereas outside such time periods a lower tail current is sufficient to keep the comparator in an idle operation mode from which the comparator can smoothly pass into the high-precision mode without adverse side-effects such as oscillations.

The total current consumption of the comparator 400 over a readout period can be significantly lower than the total current consumption of comparative ones without switchable tail current circuit over the same readout period. Since in solid-state imaging devices as illustrated in FIG. 1 each vertical signal line requires to be connected to a different comparator, the number of comparators corresponds to the number of columns in the pixel array unit, which may go into the hundreds. Reducing the power consumption of all comparators results in significant reduction of the overall power consumption in a solid-state imaging device.

When used in combination with a counter, as it is the case in an analog-to-digital converter, e.g. in the ADC 14 of FIG. 4, high accuracy for the comparator is required only for the counting period. Since a change of the comparator output signal VCO from high level to low level or vice versa indicates the end of a counting period, the change of the tail current from the high current to the low current can be directly or indirectly (with a delay) triggered by the comparator output signal VCO.

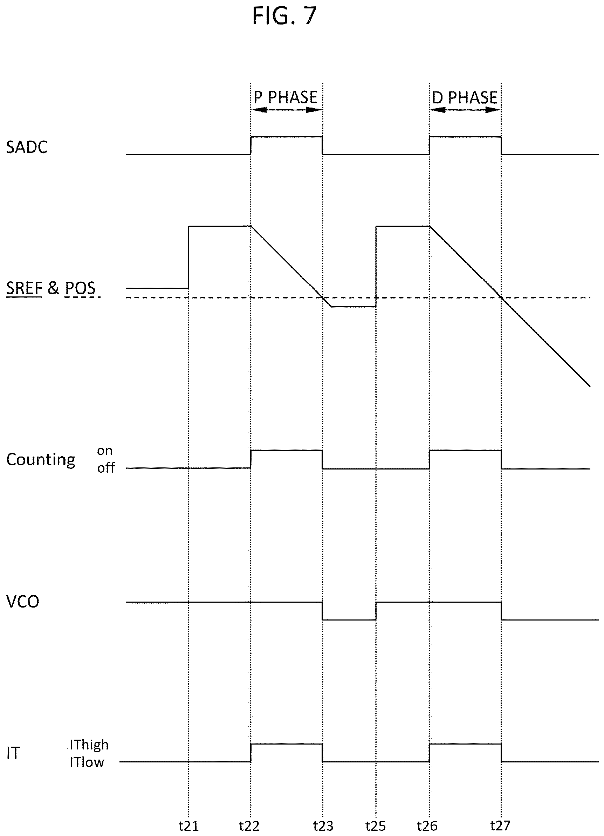

The diagram in FIG. 7 refers to a reading cycle of the pixel circuit 11P of FIG. 2 connected to a comparator 400 as illustrated in FIG. 6, wherein the comparator output signal VCO is electrically coupled to a counting input of the counter 24 of FIG. 2. The reading cycle includes a P phase (preset phase) for reading the offset pixel voltage and a D phase (date phase) for reading the pixel output signal as described with reference to FIG. 5. In the following, reference is made to a CDS reading cycle for illustrative purpose.

The diagram shows an ADC control signal SADC, a combined representation of the reference signal SREF as continuous line and a pixel output signal POS of a dark pixel as broken line, a comparator output signal VCO, the state of the counter 24 of FIG. 4, and the tail current IT supplied by the tail current circuit 450 of FIG. 6.

Prior to the end of the reset pulse, e.g. prior to the start of the reset pulse, the reference signal SREF output by the DAC 22 of FIG. 4 may change from the low level to the high level at t=t21. At the same point in time the tail current circuit 450 in FIG. 6 supplies a low tail current ITlow.

At t=t22 a change of the ADC control signal SADC from the low level to the high level starts the P phase by synchronously starting the DAC 22 and the counter 24. Shortly prior to or at t=t22, the tail current circuit 450 in FIG. 6 begins to supply a high tail current IThigh.

After starting the DAC 22, the reference signal SREF steadily decreases with time.

When at t=t23 the level of the reference signal SREF falls below the level of the pixel output signal POS, the comparator output signal VCO is inverted, thereby changing, e.g., from the high level to the low level.

At t=23 or shortly thereafter, the tail current circuit 450 in FIG. 6 starts to supply the low tail current ITlow.

In the meantime, beginning from the start of the P phase, the counter 24 steadily increases a count value and ends the count of the count value at t=t23. The count value at t=t23 is the P phase data and corresponds to a pixel offset voltage representative for the momentary noise in the pixel circuit 11P.

At t=t25 the reference signal SREF is increased again to the voltage level at the start of the P phase. Accordingly, the comparator output signal VCO changes again to the high level.

Thereafter, the transfer transistor is turned on for a predetermined time period and the charge of the photoelectric conversion element is transferred to and accumulated in the floating diffusion region. The pixel output voltage POS decreases by a voltage amount determined by the electric charge in the floating diffusion region.

FIG. 7 refers to an unilluminated pixel (dark pixel). Since the photoelectric conversion device accumulates no or only few electric charge, the level of the pixel output signal POS shows no or only weak change.

At t=t26 the ADC control signal SADC starts the D phase of the CDS reading cycle by synchronously starting both the DAC 22 and the counter 24 of FIG. 4. The level of the reference signal SREF again starts decreasing. Shortly prior to or at t=t26, the tail current circuit 450 in FIG. 6 begins to supply again the high tail current IThigh.

When at t=t27 the level of the reference signal SREF falls below the level of the pixel output signal POS, the comparator output signal VCO is inverted, thereby changing, e.g., from the high level to the low level.

At t=27 or shortly thereafter, the tail current circuit 450 in FIG. 6 starts again to supply the low tail current ITlow.

In the meantime, beginning from the start of the D phase, the counter 24 steadily increases the count value and ends the count of the count value at t=t27. The count value at t=t27 is the D phase data and represents a digital pixel value of the pixel output signal POS. The digital pixel value obtained in the D phase may be corrected on the basis of the digital value of the pixel offset voltage obtained as result of the P phase.

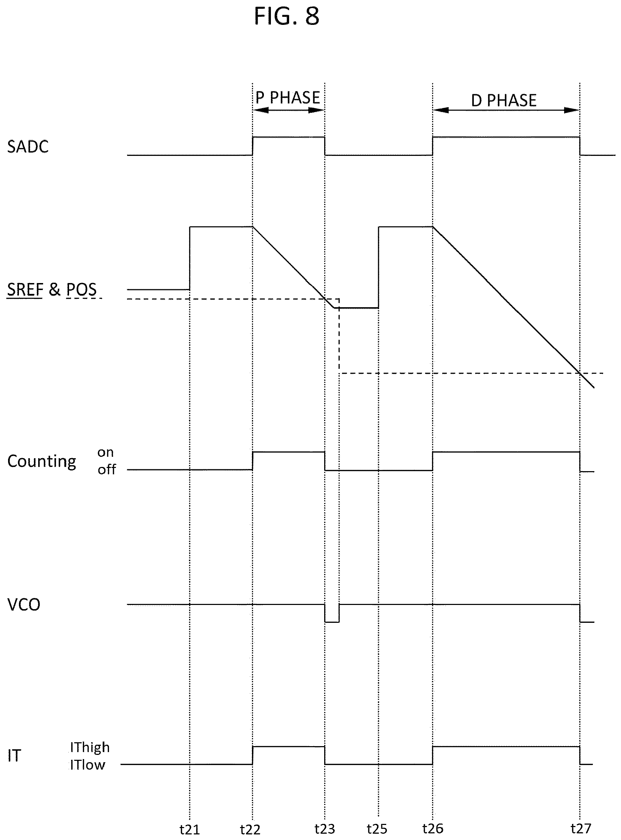

The diagram in FIG. 8 shows a corresponding reading cycle for an illuminated pixel (bright pixel).

When the transfer transistor is turned on for a predetermined time period, the charge of the illuminated photoelectric conversion element is transferred to and accumulated in the floating diffusion region. Between t=t23 and t=t25, the pixel output voltage POS decreases by a voltage amount determined by the electric charge in the floating diffusion region. Since the level of the pixel output voltage POS falls below the reference voltage signal, at the same time the comparator output signal VCO is inverted.

Since for the illuminated case the photoelectric conversion device accumulates a comparatively high amount of electric charge, the reference signal SREF needs more time to fall below the pixel output signal POS. The D phase for the bright pixel is longer than for the dark pixel and the count value of the counter 24 of FIG. 4 at t=t27 higher.

As for the case of the dark pixel in FIG. 7, the tail current circuit 450 of FIG. 6 supplies the high tail current at least in the P phase and the D phase and the low tail current in the rest. The tail current circuit 450 may start to supply the high tail current IThigh at or shortly before the start of the P phase at t=t22 and at or shortly before the start of the D phase at t=t26. The tail current circuit 450 may stop to supply the high tail current IThigh at or shortly after the end of the P phase at t=t23 and/or at or shortly after the end of the D phase t=t27.

By supplying the high tail current IThigh only in such sub-periods of the reading cycle in which high tail current has a positive effect on accuracy, the power consumption of the comparator can be reduced significantly.

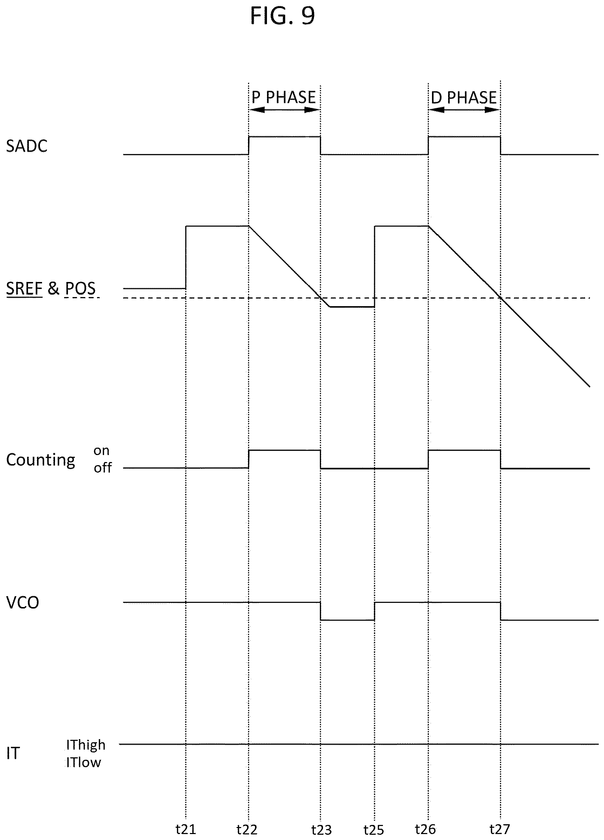

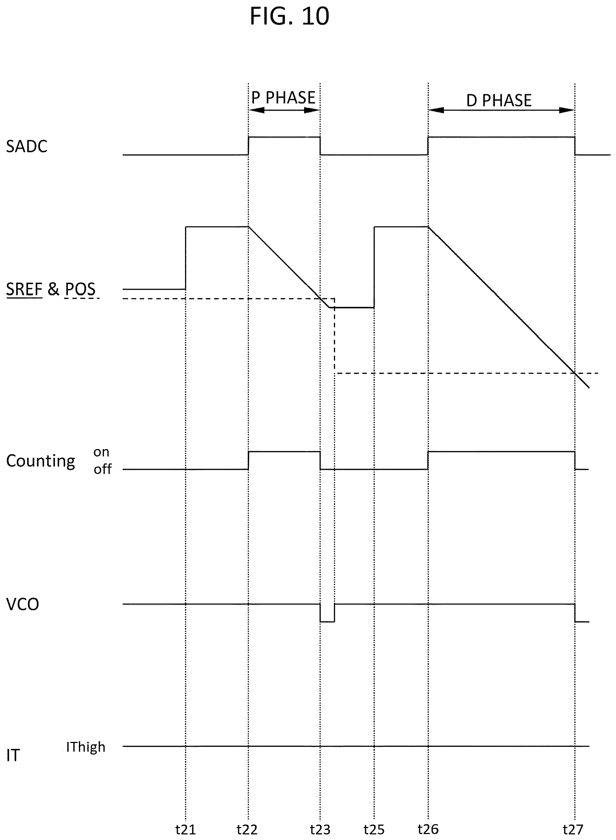

FIGS. 9 and 10 show the corresponding time signals and the tail current for a comparative ADC with constant tail current. Since the tail current is not reduced prior to the P phase and between the P phase and the D phase, power consumption is steadily high.

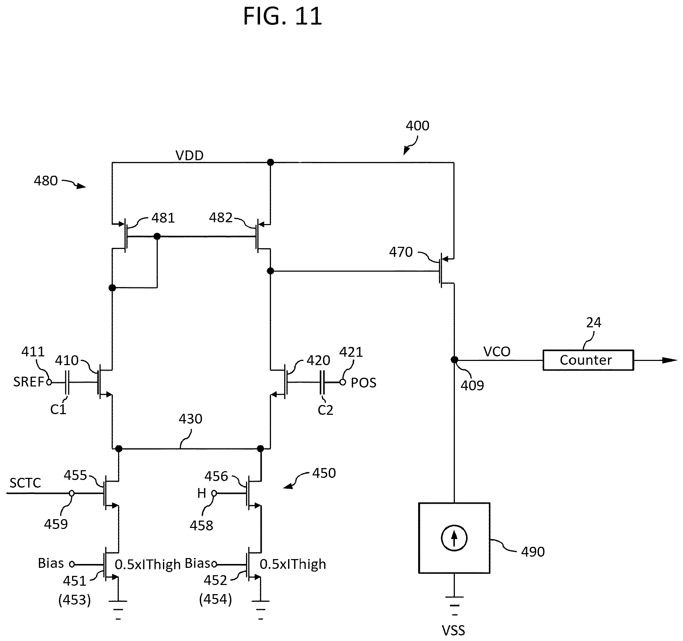

FIG. 11 shows a comparator 400 with an integrated output stage including an output transistor 470 and an output current source 490. The output transistor 470 and the output current source 490 are electrically connected in series between the positive supply voltage VDD and the negative supply voltage VSS.

The source of the output transistor 470 is electrically connected to the positive supply voltage VDD. The drain is electrically connected to the output current source 490 and to the output node 409, which may be directly connected to an input of a counter, e.g. the counter 24 in FIG. 1. The output transistor 470 may be p-FET.

The gate of the output transistor 470 is electrically connected to the drain of the second transistor 420 of the differential pair.

The output current source 490 may supply a constant output current.

The output stage may invert the signal at the output node 409, with regard to the signal at the drain of the second transistor 420. For example, the comparator output signal VCO may have a low voltage level, when the level of the first input signal applied to the first control input 411 has a lower voltage level than a second input signal applied to the second control input 421 and the comparator output signal VCO may have a high voltage level, when the level of the first input signal has a higher voltage level than the second input signal.

The collector circuit 480 includes a current mirror with a first current mirror transistor 481 electrically connected in series between the positive voltage supply VDD and the first transistor 410 and with a second current mirror transistor 482 electrically connected in series between the positive voltage supply VDD and the second transistor 420. The drains of the first and second current mirror transistors 481, 482 are electrically connected to the positive supply voltage VDD. The gates of the first and second current mirror transistors 481, 482 are electrically connected to each other and to the drain of the first transistor 410. The first and second current mirror transistors 481, 482 may be p-FETs.

A reference signal SREF output by a reference signal source, e.g. the DAC 22 of FIG. 4, is applied to the first control input 411 through the first capacitor C1. A second input signal, e.g. the pixel output signal POS of FIG. 4 is applied to the second control input 421 through a second capacitor C2.

The tail current circuit 450 includes a first current path and a second current path. The first current path and the second current path are electrically connected in parallel to each other between the common node 430 and the negative supply voltage VSS. The first current path includes a first current source 451. The second current path includes a second current source 452. The first current path is arranged to be opened in response to a change of the tail current control signal SCTC applied to the tail current control input 459.

In the illustrated example, the first current source 451 includes a first auxiliary transistor 453 with biased control input and the second current source 452 includes a second auxiliary transistor 454 with biased control input. The first and second auxiliary transistors 453, 454 may be n-FETs with positively biased gates, wherein the bias voltages at the gates are selected to control a predetermined drain current through the respective auxiliary transistor 453, 454.

The first auxiliary transistor 453 and the second auxiliary transistor 454 may match and may provide the same drain current at the same positive bias at the control input. The first auxiliary transistor 453 and the second auxiliary transistor 454 may be continuously in an on-state thereby providing a predetermined current flow in the respective current path. A difference between a first saturation current of the first auxiliary transistor 453 and a second saturation current of the second auxiliary transistor 454 may be less than 20%, e.g. less than 10% of a sum of the first and second saturation currents.

In addition, the first current path may include a first switching transistor 455, wherein the first switching transistor 455 and the first auxiliary transistor 453 are electrically arranged in series. The tail current control input 459 and a control input of the first switching transistor 455 are electrically connected. The first switching transistor 455 may be an n-FET, wherein the tail current control input 459 is connected to the gate of the n-FET.

The second current path may include a second switching transistor 456. The second switching transistor 456 and the second auxiliary transistor 454 may be electrically arranged in series. The second switching transistor 456 may be an n-FET. The control input 458 of the second switching transistor 456 may be held constantly at high level such that the second switching transistor 456 is constantly in the on-state. For example, the gate of the second switching transistor 456 is electrically connected to the positive supply voltage VDD. Thus, the second current path supplies a time-invariant, constant portion of the tail current. The constant portion may be 50% of the maximum tail current. For example, the second current path constantly supplies 5µA when the maximum tail current is 10µA.

The first current path is responsive to a level change of the tail current control signal SCTC. In particular, the first switching transistor 455 turns on, when the tail current control signal SCTC switches to high level, and turns off, when the tail current control signal SCTC switches to low level. Thus, the first current path supplies a time-variant portion of the tail current. The time-variant portion may be between 0A and 50% of the maximum tail current. For example, the second current path alternatingly supplies 0µA or 5µA when the maximum tail current is 10µA.

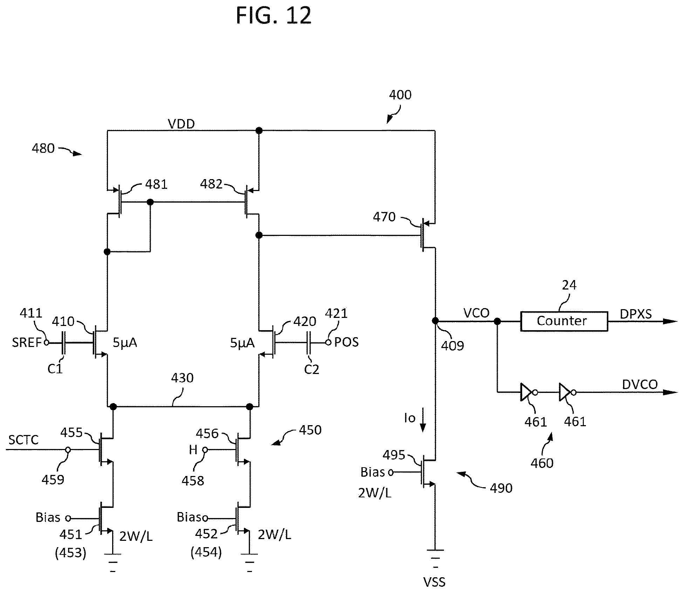

In FIG. 12 the output current source 490 includes a third auxiliary transistor 495. The third auxiliary transistor 495 may be an n-FET which gate is biased to supply a predetermined output stage current IO. The first, second and third auxiliary transistors 453, 454, 495 may have the same configuration, e.g. the same ratio between channel width W and channel length L.

In addition, the comparator 400 includes a delay circuit 460. The delay circuit 460 is electrically connected to the output node 409 and may be electrically in parallel with a counting input of the counter 24. The delay circuit 460 generates a delayed comparator output signal DVCO, wherein at least one of the rising and falling slopes of the delayed comparator output signal DVCO is delayed with respect to a respective slope of the comparator output signal VCO.

In FIG. 12 the delay circuit 460 includes two inverters 461. In other examples (not illustrated) the delay circuit 460 may include any other number of inverters 461. Alternatively, each inverter 461 may stand for the propagation delay of one or more integrated circuits of arbitrary type electrically connected to the output node 409. The falling slope of the delayed comparator output signal DVCO may be used to trigger a falling slope of the tail current control signal SCTC.

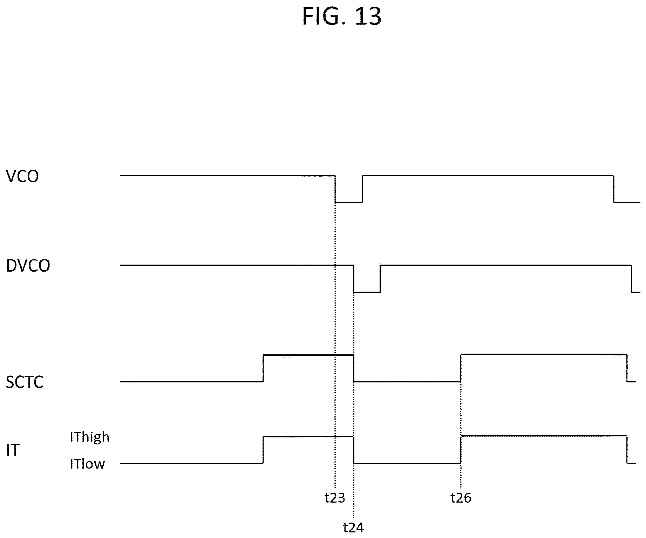

FIG. 13 illustrates an exemplary timing of the comparator output signal VCO, the delayed comparator output signal DVCO, the tail current control signal SCTC and the tail current IT of the ADC 14 of FIG. 12.

Up to t=t23 the ADC 14 of FIG. 12 is in a counting mode. The comparator output signal VCO, the delayed comparator output signal DVCO and the tail current control signal SCTC have high level. The tail current circuit 450 of FIG. 12 supplies high tail current to facilitate a precise control of the comparator output signal VCO.

At t=t23 the comparator output signal VCO changes from high level to low level, indicating the end of the counting period and stopping the counter 24.

At t=t24 the falling slope of the delayed comparator output signal DVCO follows the falling slope of the comparator output signal VCO delayed in time. The delayed comparator output signal DVCO changes from high level to low level thereby triggering the change from high level to low level of the tail current control signal SCTC. The tail current circuit 450 of FIG. 12 begins to supply the low tail current. In this way, the transition of the tail current from the high tail current to the low tail current is sufficiently delayed in time with respect to the falling slope of the comparator output signal VCO such that even at the reduced accuracy of the comparator 400 operating with the low tail current, the comparator is save from erroneously changing to the high level again for a short time.

At t=t26 the tail current control signal SCTC may change from low level to high level. The change may be effected by lapse of a specific period of time. Alternatively, the change of the tail current control signal SCTC from low level to high level may be directly or indirectly triggered by a signal that also controls the start of counting, e.g. a signal generated by the sensor controller 15 illustrated in FIG. 1.

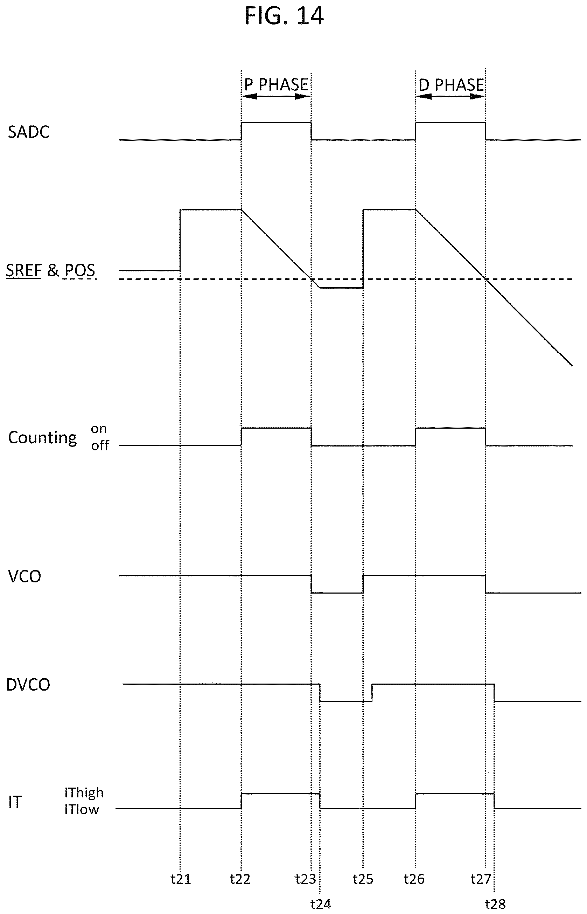

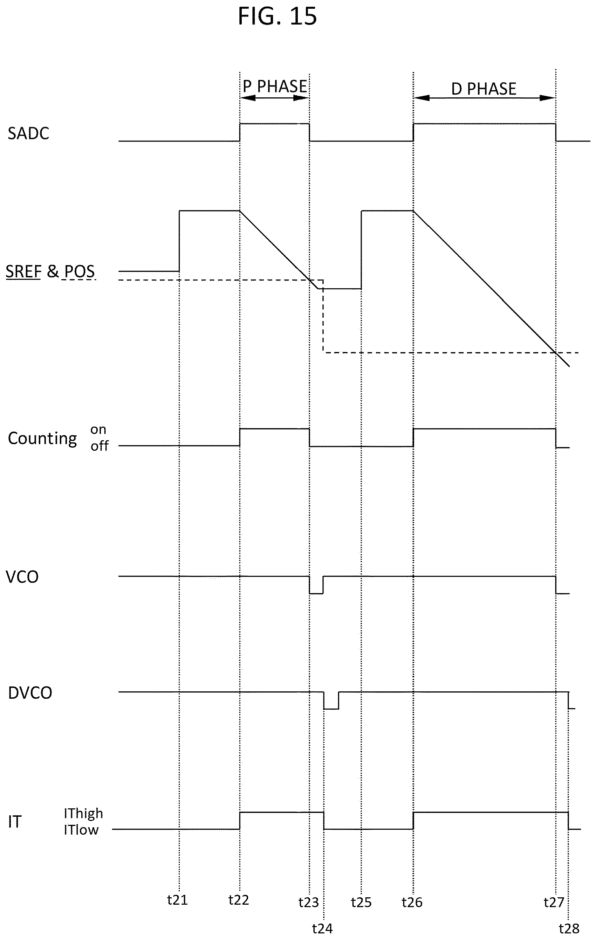

The signal timings in FIGS. 14 and 15 correspond to that in FIGS. 7 and 8 with the only difference that the tail current circuit changes from supplying the high tail current IThigh to supplying the low tail current at t=t24 of FIG. 13, i.e. when the delayed comparator output voltage DVCO changes from the high level to the low level.

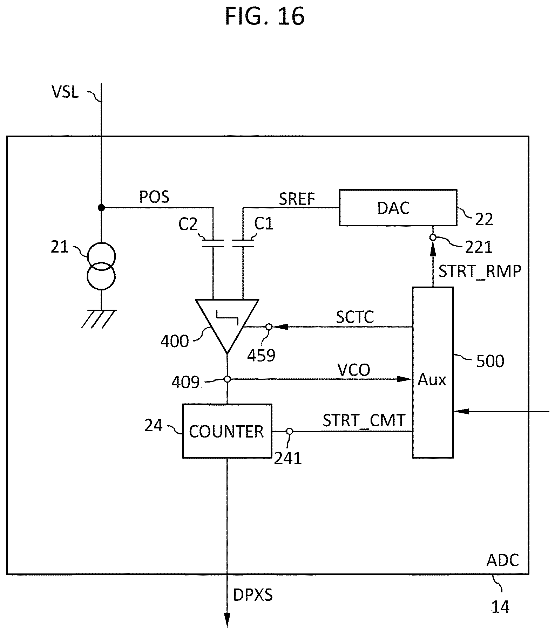

FIG. 16 shows an ADC 14 with an auxiliary control circuit 500. The auxiliary control circuit 500 may receive the comparator output signal VCO and may include a delay circuit for generating the delayed comparator output signal DVCO. Alternatively, the auxiliary control circuit 500 may directly receive the delayed comparator output signal DVCO. The auxiliary control circuit 500 may receive a further control signal synchronized with the P phase and/or the D phase.

A first output of the auxiliary control circuit 500 is connected to a control input 221 of the DAC 22. A second output of the auxiliary control circuit 500 is connected to the tail current control input 459 of the comparator 400. The auxiliary control circuit 500 may provide a suitably synchronized change of a first digital control signal STRT_RMP applied to the control input 221 of the DAC 22, a second digital control signal STRT_CNT applied to a control input 241 of the counter 24, and the tail current control signal SCTC applied to the tail current control input 459.

The auxiliary control circuit 500 may be partially or fully integrated in the sensor controller 15 illustrated in FIG. 1. Alternatively, the auxiliary control circuit 500 may be fully integrated in each ADC 14. Alternatively, parts of the auxiliary control circuit 500 may be integrated in each ADC 14 and other parts may be integrated in the sensor controller 15 illustrated in FIG. 1

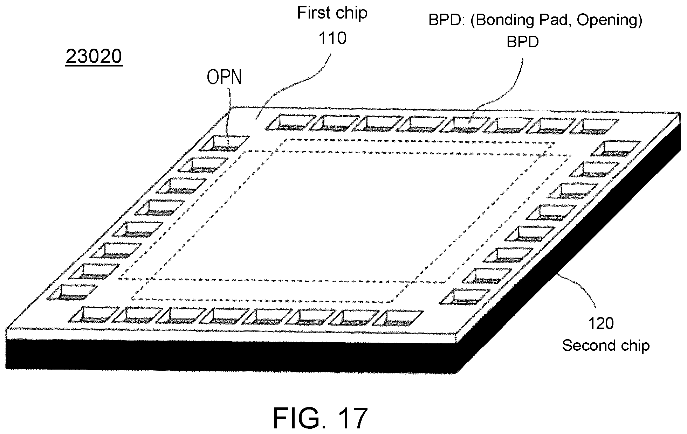

FIG. 17 is a perspective view showing an example of a laminated structure of a solid-state imaging device 23020 with a plurality of pixel circuits arranged matrix-like in array form. Each pixel circuit has at least one photoelectric conversion element.

The solid-state imaging device 23020 has the laminated structure of a first chip (upper chip) 110 and a second chip (lower chip) 120.

The laminated first and second chips 110 and 120 may be electrically connected to each other through TC(S)Vs (Through Contact (Silicon) Vias) formed in the first chip 110.

The solid-state imaging device 23020 may be formed to have the laminated structure in such a manner that the first and second chips 110 and 120 are bonded together at a wafer level and cut out by dicing.

In the laminated structure of the upper and lower two chips, the first chip 110 may be an analog chip (sensor chip) including at least one analog component of each pixel circuit, e.g., the photoelectric conversion elements arranged in array form. For example, the first chip 110 may include only the photoelectric conversion elements. Alternatively, the first chip 110 may include, in addition to the photoelectric conversion element one, two, three or four of the active elements (transfer transistor TG, reset transistor RST, amplification transistor AMO, and selection transistor SEL) of each pixel circuit.

The first chip 110 may also include logic circuits. For example, the first chip 110 may include portions of the ADC, e.g. at least one of the comparator 400, the counter 24, the current source 21 and the DAC 22, may include parts of the comparator 400, or may include the complete ADC as illustrated in FIG. 4 for each column of pixel circuits. The first chip 110 may also include at least portions of the address decoder 12, the pixel timing driving unit 13 and the sensor controller 15 as illustrated in FIG. 1.

The second chip 120 may be mainly a logic chip (digital chip) that includes the elements complementing the circuits on the first chip 110 to the solid-state imaging device 23020. The second chip 120 may also include analog circuits, for example circuits that quantize analog signals transferred from the first chip 110 through the TCVs and to a signal processing circuit.

The second chip 120 may have one or more bonding pads BPD and the first chip 110 may have openings OPN for use in wire-bonding to the second chip 120.

The solid-state imaging device 23020 with the laminated structure of the two chips 110, 120 may have the following characteristic configuration.

The electrical connection between the first chip 110 and the second chip 120 is performed through, for example, the TCVs.

The TCVs may be arranged at chip ends or between a pad region and a circuit region.

The TCVs for transmitting control signals and supplying power are mainly concentrated at, for example, the four corners of the solid-state imaging device 23020, by which a signal wiring area of the first chip 110 can be reduced.

A reduction in the number of the wiring layers of the first chip 110 may result in an increase in the resistance of a power supply line and an increase in IR-Drop. As countermeasures for this problem, the effective arrangement of the TCVs can improve the noise control, stable supply, or the like of a power supply in the first chip 110 using the wiring of the second chip 120.

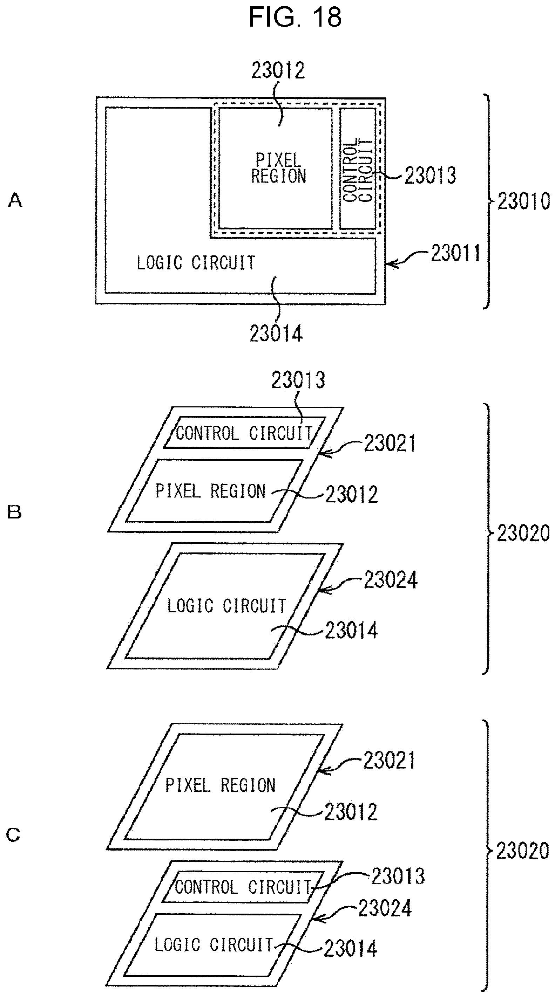

FIG. 18 illustrates schematic configuration examples of solid- state imaging devices 23010, 23020.

The single-layer solid-state imaging device 23010 illustrated in A of FIG. 18 includes a single die (semiconductor substrate) 23011. Mounted and/or formed on the die 23011 are a pixel region 23012 (pixel array unit), a control circuit 23013 (address decoder, pixel timing driving unit, sensor controller), and a logic circuit 23014 (ADC, Latches). In the pixel region 23012, pixels (pixel circuits) are disposed in an array form. The control circuit 23013 performs various kinds of control including control of driving the pixels. The logic circuit 23014 performs signal processing.

B and C of FIG. 18 illustrate schematic configuration examples of multi-layer solid-state imaging devices 23020. As illustrated in B and C of FIG. 18, two dies (chips), namely a sensor die 23021 (first chip) and a logic die 23024 (second chip), are stacked in a solid-state imaging device 23020. These dies are electrically coupled to form a single semiconductor chip.

With reference to B of FIG. 18, the pixel region 23012 and the control circuit 23013 are formed or mounted on the sensor die 23021, and the logic circuit 23014 is formed or mounted on the logic die 23024. The logic circuit 23014 includes a signal processing circuit that processes signals.

With reference to C of FIG. 18, the pixel region 23012 is formed or mounted on the sensor die 23021, whereas the control circuit 23013 and the logic circuit 23014 are formed or mounted on the logic die 23024.

According to another example (not illustrated), the pixel region 23012 and the logic circuit 23014, or the pixel region 23012 and parts of the logic circuit 23014 may be formed or mounted on the sensor die 23021, and the control circuit 23013 is formed or mounted on the logic die 23024.

### <Application Example to In-Vivo Information Acquisition System>

The present disclosure technology (this technology) can be applied to various products. For example, the present disclosure technology may be applied to the endoscopic surgery system.

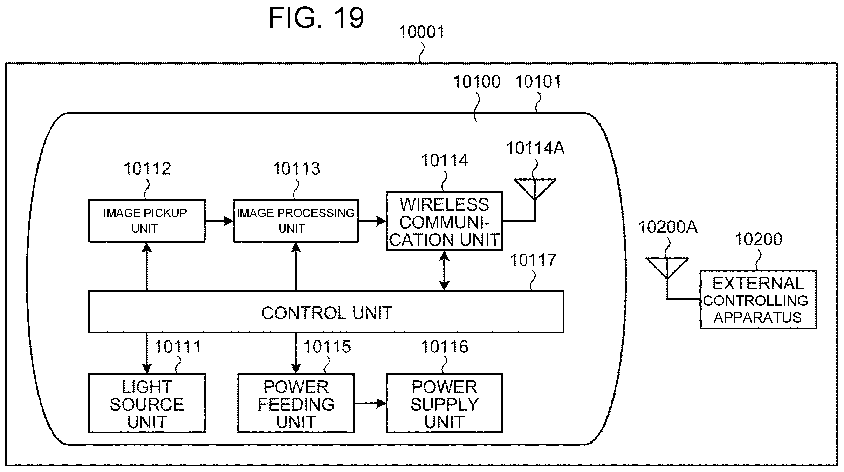

FIG. 19 is a block diagram depicting an example of a schematic configuration of an in-vivo information acquisition system of a patient using a capsule type endoscope, to which the technology according to an embodiment of the present disclosure (present technology) can be applied.

The in-vivo information acquisition system 10001 includes a capsule type endoscope 10100 and an external controlling apparatus 10200.

The capsule type endoscope 10100 is swallowed by a patient at the time of inspection. The capsule type endoscope 10100 has an image pickup function and a wireless communication function and successively picks up an image of the inside of an organ such as the stomach or an intestine (hereinafter referred to as in-vivo image) at predetermined intervals while it moves inside of the organ by peristaltic motion for a period of time until it is naturally discharged from the patient. Then, the capsule type endoscope 10100 successively transmits information of the in-vivo image to the external controlling apparatus 10200 outside the body by wireless transmission.

The external controlling apparatus 10200 integrally controls operation of the in-vivo information acquisition system 10001. Further, the external controlling apparatus 10200 receives information of an in-vivo image transmitted thereto from the capsule type endoscope 10100 and generates image data for displaying the in-vivo image on a display apparatus (not depicted) on the basis of the received information of the in-vivo image.

In the in-vivo information acquisition system 10001, an in-vivo image imaged a state of the inside of the body of a patient can be acquired at any time in this manner for a period of time until the capsule type endoscope 10100 is discharged after it is swallowed.

A configuration and functions of the capsule type endoscope 10100 and the external controlling apparatus 10200 are described in more detail below.

The capsule type endoscope 10100 includes a housing 10101 of the capsule type, in which a light source unit 10111, an image pickup unit 10112, an image processing unit 10113, a wireless communication unit 10114, a power feeding unit 10115, a power supply unit 10116 and a control unit 10117 are accommodated.

The light source unit 10111 includes a light source such as, for example, a light emitting diode (LED) and irradiates light on an image pickup field-of-view of the image pickup unit 10112.

The image pickup unit 10112 includes an image pickup element and an optical system including a plurality of lenses provided at a preceding stage to the image pickup element. Reflected light (hereinafter referred to as observation light) of light irradiated on a body tissue which is an observation target is condensed by the optical system and introduced into the image pickup element. In the image pickup unit 10112, the incident observation light is photoelectrically converted by the image pickup element, by which an image signal corresponding to the observation light is generated. The image signal generated by the image pickup unit 10112 is provided to the image processing unit 10113.

The image processing unit 10113 includes a processor such as a central processing unit (CPU) or a graphics processing unit (GPU) and performs various signal processes for an image signal generated by the image pickup unit 10112. The image processing unit 10113 provides the image signal for which the signal processes have been performed thereby as RAW data to the wireless communication unit 10114.

The wireless communication unit 10114 performs a predetermined process such as a modulation process for the image signal for which the signal processes have been performed by the image processing unit 10113 and transmits the resulting image signal to the external controlling apparatus 10200 through an antenna 10114A. Further, the wireless communication unit 10114 receives a control signal relating to driving control of the capsule type endoscope 10100 from the external controlling apparatus 10200 through the antenna 10114A. The wireless communication unit 10114 provides the control signal received from the external controlling apparatus 10200 to the control unit 10117.

The power feeding unit 10115 includes an antenna coil for power reception, a power regeneration circuit for regenerating electric power from current generated in the antenna coil, a voltage booster circuit and so forth. The power feeding unit 10115 generates electric power using the principle of non-contact charging.

The power supply unit 10116 includes a secondary battery and stores electric power generated by the power feeding unit 10115. In FIG. 19, in order to avoid complicated illustration, an arrow mark indicative of a supply destination of electric power from the power supply unit 10116 and so forth are omitted. However, electric power stored in the power supply unit 10116 is supplied to and can be used to drive the light source unit 10111, the image pickup unit 10112, the image processing unit 10113, the wireless communication unit 10114 and the control unit 10117.

The control unit 10117 includes a processor such as a CPU and suitably controls driving of the light source unit 10111, the image pickup unit 10112, the image processing unit 10113, the wireless communication unit 10114 and the power feeding unit 10115 in accordance with a control signal transmitted thereto from the external controlling apparatus 10200.

The external controlling apparatus 10200 includes a processor such as a CPU or a GPU, a microcomputer, a control board or the like in which a processor and a storage element such as a memory are incorporated. The external controlling apparatus 10200 transmits a control signal to the control unit 10117 of the capsule type endoscope 10100 through an antenna 10200A to control operation of the capsule type endoscope 10100. In the capsule type endoscope 10100, an irradiation condition of light upon an observation target of the light source unit 10111 can be changed, for example, in accordance with a control signal from the external controlling apparatus 10200. Further, an image pickup condition (for example, a frame rate, an exposure value or the like of the image pickup unit 10112 can be changed in accordance with a control signal from the external controlling apparatus 10200. Further, the substance of processing by the image processing unit 10113 or a condition for transmitting an image signal from the wireless communication unit 10114 (for example, a transmission interval, a transmission image number or the like) may be changed in accordance with a control signal from the external controlling apparatus 10200.

Further, the external controlling apparatus 10200 performs various image processes for an image signal transmitted thereto from the capsule type endoscope 10100 to generate image data for displaying a picked up in-vivo image on the display apparatus. As the image processes, various signal processes can be performed such as, for example, a development process (de-mosaic process), an image quality improving process (bandwidth enhancement process, a super-resolution process, a noise reduction (NR) process and/or image stabilization process) and/or an enlargement process (electronic zooming process). The external controlling apparatus 10200 controls driving of the display apparatus to cause the display apparatus to display a picked up in-vivo image on the basis of generated image data. Alternatively, the external controlling apparatus 10200 may also control a recording apparatus (not depicted) to record generated image data or control a printing apparatus (not depicted) to output generated image data by printing.

The example of the in-vivo information acquisition system to which the technology according to an embodiment of the present disclosure is applied has been described above. For example, by applying the comparator with switchable tail current circuit as described above to the image pickup unit 10112 it is possible to reduce power consumption of the capsule type endoscope 10100 and to ease demands on the power feeding unit 10115.

### <Application Example to Mobile Body>

The technology according to the present disclosure may also be realized as a device mounted in a mobile body of any type such as automobile, electric vehicle, hybrid electric vehicle, motorcycle, bicycle, personal mobility, airplane, drone, ship, or robot.

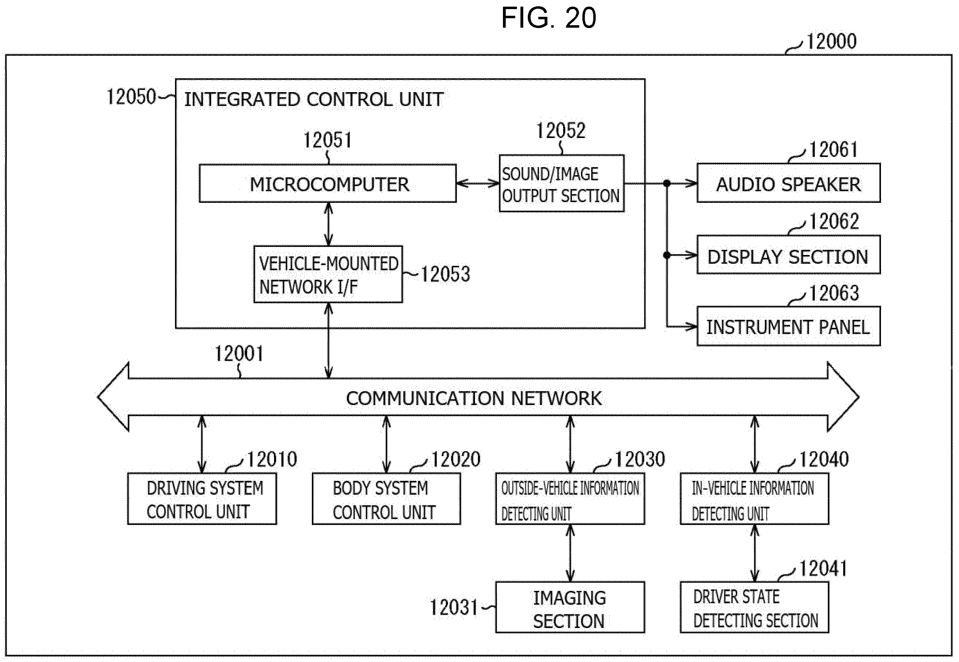

FIG. 20 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 20, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 imaging an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automatic driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound or an image to an output device capable of visually or audible notifying information to an occupant of the vehicle or the outside of the vehicle. In the example of FIG. 20, an audio speaker 12061, a display section 12062, and an instrument panel 12063 are illustrated as the output device. The display section 12062 may, for example, include at least one of an on-board display or a head-up display.

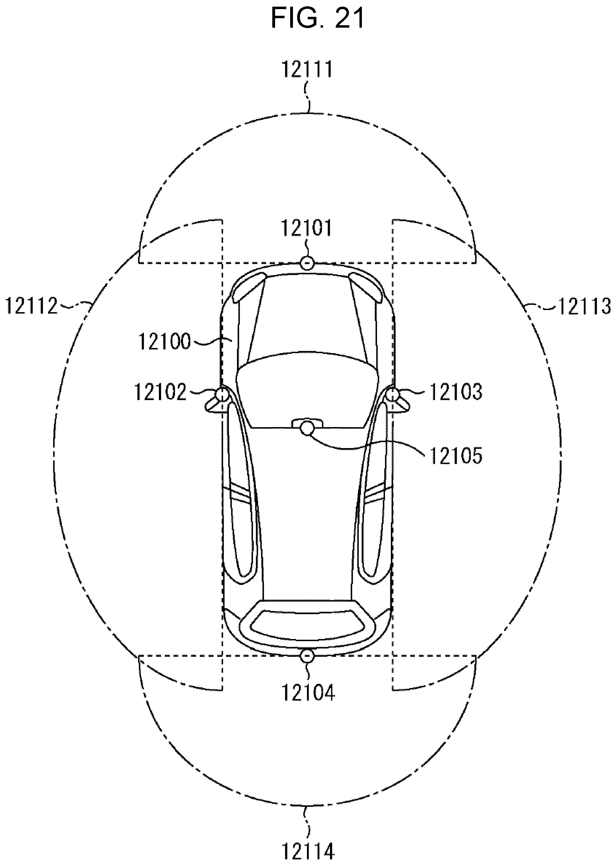

FIG. 21 is a diagram depicting an example of the installation position of the imaging section 12031.

In FIG. 21, the imaging section 12031 includes imaging sections 12101, 12102, 12103, 12104, and 12105.

The imaging sections 12101, 12102, 12103, 12104, and 12105 are, for example, disposed at positions on a front nose, side-view mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the side view mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 21 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the side view mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automatic driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The example of the vehicle control system to which the technology according to an embodiment of the present disclosure is applicable has been described above. For example, by applying the comparator with switchable tail current circuit as described above to the imaging section 12031, it is possible to reduce power consumption without adversely affecting driving support.

Additionally, embodiments of the present technology are not limited to the above-described embodiments, but various changes can be made within the scope of the present technology without departing from the gist of the present technology.

## Claims

1. An analog-to-digital converter (14), comprising:
a comparator (400) comprising:
a differential pair (410, 420) comprising a first transistor (410) and a second transistor (420), the first transistor (410) comprising a first control input and the second transistor (420) comprising a second control input;
a common node (430) electrically connected to the first transistor (410) and the second transistor (420);
an integrated output stage comprising an output transistor (470) and an output current source (490) electrically connected in series between a positive supply voltage and a negative supply voltage, wherein an output node (409) electrically connected to the differential pair (410, 420) is between the output transistor (470) and the output current source (490);
a tail current circuit (450) electrically connected to the common node (430) and comprising a tail current control input (459), wherein the tail current circuit (450) is configured to supply a first tail current to the differential pair (410, 420) in a first mode and a second tail current in a second mode and wherein the tail current circuit (450) is configured to switch between the first mode and the second mode in response to a tail current control signal applied to the tail current control input (459); and
a delay circuit (460) electrically connected to the output node (409) and configured to generate a delayed comparator output signal, wherein at least one of the rising and falling slopes of the delayed comparator output signal is delayed with respect to a respective slope of the comparator output signal, and wherein the tail current circuit (450) is configured to switch between the first mode and the second mode in response to a change of a level of the delayed comparator output signal.

2. The analog-to-digital converter according to the preceding claim, further comprising:
a collector circuit (480) electrically connected with the differential pair (410, 420) and the output node (409), wherein the collector circuit (480) and the differential pair (410, 420) are configured to generate a digital comparator output signal at the output node (409).

3. The analog-to-digital converter according to the preceding claim,
wherein the collector circuit (480) comprises a current mirror (481, 482).

4. The analog-to-digital converter according to any of claims 1 to 3,
wherein the tail current circuit (450) comprises a first current path and a second current path, wherein the first current path comprises a first current source (451), wherein the second current path comprises a second current source (452), wherein the first and second current paths are electrically arranged in parallel, and wherein at least one the first and second current paths is arranged to be opened in response to a change of the tail current control signal applied to the tail current control input (459).

5. The analog-to-digital converter according to the preceding claim,
wherein the first current source (451) comprises a first auxiliary transistor (453) with biased control input and wherein the second current source (452) comprises a second auxiliary transistor (454) with biased control input.

6. The analog-to-digital converter according to the preceding claim,
wherein a difference between a first saturation current of the first auxiliary transistor (453) and a second saturation current of the second auxiliary transistor (454) is less than 20% of a sum of the first and second saturation currents.

7. The analog-to-digital converter according to any of claims 4 to 6,
wherein the first current path further comprises a first switching transistor (455), wherein the first current source (451) and the first switching transistor (455) are electrically arranged in series, and wherein the tail current control input (459) and a control input of the first switching transistor (455) are electrically connected.

8. The analog-to-digital converter according to any of claims 4 to 7,
wherein the second current path further comprises a second switching transistor (456), and wherein the second current source (452) and the second switching transistor (456) are electrically arranged in series.

9. The analog-to-digital converter according to claim 1,
wherein the delay circuit (460) includes an inverter (461).

10. The analog-to-digital converter according to any of claims 1 to 9,
wherein the tail current circuit (450) is configured to switch between the first mode and the second mode in response to a change of a level of a comparator output signal output through the output node (409) or the delayed comparator output signal.

11. The analog-to-digital converter according to any of the preceding claims, further comprising:
a digital-to-analog converter (22) comprising a control input and an analog output, wherein the analog output is electrically coupled to the first control input or to the second control input of the comparator (400); and
an auxiliary control circuit (500) connected to the control input of the digital-to-analog converter (22) and to the tail current control input (459) of the tail current circuit (450), wherein the auxiliary control circuit (500) is configured to provide a synchronized change of a first digital control signal applied to the control input of the digital-to-analog converter (22) and the tail current control signal applied to the tail current control input (459).

12. A solid-state imaging device, comprising:
a pixel array unit (11) comprising a plurality of pixel circuits (11P) arranged in matrix form, the pixel circuits (11P) being configured to perform photoelectric conversion; and
the analog-to-digital converter (14) according to any of the preceding claims.

13. A camera system, comprising:
the solid-state imaging device (230200) according to the preceding claim; and an optical system configured to form a subject image on the solid-sate imaging device (23020).

## Patentansprüche

1. Analog-Digital-Wandler (14), umfassend:
einen Komparator (400), umfassend:
ein Differentialpaar (410, 420), das einen ersten Transistor (410) und einen zweiten Transistor (420) umfasst, wobei der erste Transistor (410) einen ersten Steuereingang umfasst und der zweite Transistor (420) einen zweiten Steuereingang umfasst;
einen gemeinsamen Knoten (430), der elektrisch mit dem ersten Transistor (410) und dem zweiten Transistor (420) verbunden ist;
eine integrierte Ausgangsstufe, die einen Ausgangstransistor (470) und eine Ausgangsstromquelle (490) umfasst, die elektrisch in Reihe zwischen einer positiven Versorgungsspannung und einer negativen Versorgungsspannung geschaltet sind, wobei ein Ausgangsknoten (409), der elektrisch mit dem Differentialpaar (410, 420) verbunden ist, zwischen dem Ausgangstransistor (470) und der Ausgangsstromquelle (490) liegt;
eine Schwanzstromschaltung (450), die elektrisch mit dem gemeinsamen Knoten (430) verbunden ist und einen Schwanzstromsteuereingang (459) umfasst, wobei die Schwanzstromschaltung (450) konfiguriert ist, um einen ersten Schwanzstrom an das Differentialpaar (410, 420) in einem ersten Modus und einen zweiten Schwanzstrom in einem zweiten Modus zu liefern und wobei die Schwanzstromschaltung (450) konfiguriert ist, um zwischen dem ersten Modus und dem zweiten Modus als Reaktion auf ein Schwanzstromsteuersignal zu schalten, das an den Schwanzstromsteuereingang (459) angelegt wird; und
eine Verzögerungsschaltung (460), die elektrisch mit dem Ausgangsknoten (409) verbunden und konfiguriert ist, um ein verzögertes Komparatorausgangssignal zu erzeugen, wobei mindestens eine der ansteigenden und abfallenden Flanken des verzögerten Komparatorausgangssignals in Bezug auf eine entsprechende Flanke des Komparatorausgangssignals verzögert ist, und wobei die Schwanzstromschaltung (450) konfiguriert ist, um zwischen dem ersten Modus und dem zweiten Modus als Reaktion auf eine Änderung eines Pegels des verzögerten Komparatorausgangssignals zu schalten.

2. Analog-Digital-Wandler nach dem vorstehenden Anspruch, ferner umfassend:
eine Kollektorschaltung (480), die elektrisch mit dem Differentialpaar (410, 420) und dem Ausgangsknoten (409) verbunden ist, wobei die Kollektorschaltung (480) und das Differentialpaar (410, 420) konfiguriert sind, um ein digitales Komparatorausgangssignal an dem Ausgangsknoten (409) zu erzeugen.

3. Analog-Digital-Wandler nach dem vorstehenden Anspruch,
wobei die Kollektorschaltung (480) einen Stromspiegel (481,482) umfasst.

4. Analog-Digital-Wandler nach einem der Ansprüche 1 bis 3,
wobei die Schwanzstromschaltung (450) einen ersten Strompfad und einen zweiten Strompfad umfasst, wobei der erste Strompfad eine erste Stromquelle (451) umfasst, wobei der zweite Strompfad eine zweite Stromquelle (452) umfasst, wobei der erste und der zweite Strompfad elektrisch parallel angeordnet sind, und wobei mindestens einer des ersten und des zweiten Strompfads angeordnet ist, um als Reaktion auf eine Änderung des Schwanzstromsteuersignals, das an den Schwanzstromsteuereingang (459) angelegt wird, geöffnet zu werden.

5. Analog-Digital-Wandler nach dem vorstehenden Anspruch,
wobei die erste Stromquelle (451) einen ersten Hilfstransistor (453) mit vorgespanntem Steuereingang umfasst und wobei die zweite Stromquelle (452) einen zweiten Hilfstransistor (454) mit vorgespanntem Steuereingang umfasst.

6. Analog-Digital-Wandler nach dem vorstehenden Anspruch,
wobei eine Differenz zwischen einem ersten Sättigungsstrom des ersten Hilfstransistors (453) und einem zweiten Sättigungsstrom des zweiten Hilfstransistors (454) weniger als 20 % einer Summe des ersten und des zweiten Sättigungsstroms beträgt.

7. Analog-Digital-Wandler nach einem der Ansprüche 4 bis 6,
wobei der erste Strompfad ferner einen ersten Schalttransistor (455) umfasst, wobei die erste Stromquelle (451) und der erste Schalttransistor (455) elektrisch in Reihe angeordnet sind, und wobei der Schwanzstromsteuereingang (459) und ein Steuereingang des ersten Schalttransistors (455) elektrisch verbunden sind.

8. Analog-Digital-Wandler nach einem der Ansprüche 4 bis 7,
wobei der zweite Strompfad ferner einen zweiten Schalttransistor (456) umfasst, und wobei die zweite Stromquelle (452) und der zweite Schalttransistor (456) elektrisch in Reihe angeordnet sind.

9. Analog-Digital-Wandler nach Anspruch 1,
wobei die Verzögerungsschaltung (460) einen Inverter (461) einschließt.

10. Analog-Digital-Wandler nach einem der Ansprüche 1 bis 9,
wobei die Schwanzstromschaltung (450) konfiguriert ist, um zwischen dem ersten Modus und dem zweiten Modus als Reaktion auf eine Änderung eines Pegels eines Komparatorausgangssignals, das durch den Ausgangsknoten (409) ausgegeben wird, oder des verzögerten Komparatorausgangssignals zu schalten.

11. Analog-Digital-Wandler nach einem der vorstehenden Ansprüche, ferner umfassend:
einen Digital-Analog-Wandler (22), der einen Steuereingang und einen Analogausgang umfasst, wobei der Analogausgang elektrisch an den ersten Steuereingang oder an den zweiten Steuereingang des Komparators (400) gekoppelt ist; und
eine Hilfssteuerschaltung (500), die mit dem Steuereingang des Digital-Analog-Wandlers (22) und mit dem Schwanzstromsteuereingang (459) der Schwanzstromschaltung (450) verbunden ist, wobei die Hilfssteuerschaltung (500) konfiguriert ist, um eine synchronisierte Änderung eines ersten digitalen Steuersignals, das an den Steuereingang des Digital-Analog-Wandlers (22) angelegt wird, und des Schwanzstromsteuersignals, das an den Schwanzstromsteuereingang (459) angelegt wird, bereitzustellen.

12. Festkörperbildgebungsvorrichtung, umfassend:
eine Pixelarrayeinheit (11), die eine Vielzahl von in Matrixform angeordneten Pixelschaltungen (11P) umfasst, wobei die Pixelschaltungen (11P) konfiguriert sind, um eine photoelektrische Umwandlung durchzuführen; und
den Analog-Digital-Wandler (14) nach einem der vorstehenden Ansprüche.

13. Kamerasystem, umfassend:
eine Festkörperbildgebungsvorrichtung (230200) nach einem der vorstehenden Ansprüche; und ein optisches System, das ein Subjektbild auf der Festkörperbildgebungsvorrichtung (23020) ausbildet.

## Revendications

1. Convertisseur analogique-numérique (14) comprenant :
un comparateur (400), comprenant :
une paire différentielle (410, 420) comprenant un premier transistor (410) et un second transistor (420), le premier transistor (410) comprenant une première entrée de commande et le second transistor (420) comprenant une seconde entrée de commande ;
un nœud commun (430) connecté électriquement au premier transistor (410) et au second transistor (420) ;
un étage de sortie intégré comprenant un transistor de sortie (470) et une source de courant de sortie (490) connectée électriquement en série entre une tension d'alimentation positive et une tension d'alimentation négative, dans lequel un nœud de sortie (409) connecté électriquement à la paire différentielle (410, 420) est entre le transistor de sortie (470) et la source de courant de sortie (490) ;
un circuit de courant de queue (450) connecté électriquement au nœud commun (430) et comprenant une entrée de commande de courant de queue (459), dans lequel le circuit de courant de queue (450) est configuré pour fournir un premier courant de queue à la paire différentielle (410, 420) dans un premier mode et un second courant de queue dans un second mode et dans lequel le circuit de courant de queue (450) est configuré pour commuter entre le premier mode et le second mode en réponse à un signal de commande de courant de queue appliqué à l'entrée de commande de courant de queue (459) ; et
un circuit de retard (460) connecté électriquement au nœud de sortie (409) et configuré pour générer un signal de sortie de comparateur retardé, dans lequel au moins l'une des pentes ascendante et descendante du signal de sortie de comparateur retardé est retardée par rapport à une pente respective du signal de sortie de comparateur, et dans lequel le circuit de courant de queue (450) est configuré pour commuter entre le premier mode et le second mode en réponse à un changement d'un niveau du signal de sortie de comparateur retardé.

2. Convertisseur analogique-numérique selon la revendication précédente, comprenant en outre :
un circuit collecteur (480) connecté électriquement à la paire différentielle (410, 420) et au nœud de sortie (409), dans lequel le circuit collecteur (480) et la paire différentielle (410, 420) sont configurés pour générer un signal de sortie de comparateur numérique au niveau du nœud de sortie (409).

3. Convertisseur analogique-numérique selon la revendication précédente,
dans lequel le circuit collecteur (480) comprend un miroir de courant (481, 482).

4. Convertisseur analogique-numérique selon l'une quelconque des revendications 1 à 3,
dans lequel le circuit de courant de queue (450) comprend un premier chemin de courant et un second chemin de courant, dans lequel le premier chemin de courant comprend une première source de courant (451), dans lequel le second chemin de courant comprend une seconde source de courant (452), dans lequel les premier et second chemins de courant sont agencés électriquement en parallèle, et dans lequel au moins l'un des premier et second chemins de courant est agencé pour être ouvert en réponse à un changement du signal de commande de courant de queue appliqué à l'entrée de commande de courant de queue (459).

5. Convertisseur analogique-numérique selon la revendication précédente,
dans lequel la première source de courant (451) comprend un premier transistor auxiliaire (453) avec une entrée de commande polarisée, et dans lequel la seconde source de courant (452) comprend un second transistor auxiliaire (454) avec une entrée de commande polarisée.

6. Convertisseur analogique-numérique selon la revendication précédente,
dans lequel une différence entre un premier courant de saturation du premier transistor auxiliaire (453) et un second courant de saturation du second transistor auxiliaire (454) est inférieure à 20 % d'une somme des premier et second courants de saturation.

7. Convertisseur analogique-numérique selon l'une quelconque des revendications 4 à 6,
dans lequel le premier chemin de courant comprend en outre un premier transistor de commutation (455), dans lequel la première source de courant (451) et le premier transistor de commutation (455) sont agencés électriquement en série, et dans lequel l'entrée de commande de courant de queue (459) et une entrée de commande du premier transistor de commutation (455) sont connectées électriquement.

8. Convertisseur analogique-numérique selon l'une quelconque des revendications 4 à 7,
dans lequel le second chemin de courant comprend en outre un second transistor de commutation (456), et dans lequel la seconde source de courant (452) et le second transistor de commutation (456) sont agencés électriquement en série.

9. Convertisseur analogique-numérique selon la revendication 1,
dans lequel le circuit de retard (460) comporte un onduleur (461).

10. Convertisseur analogique-numérique selon l'une quelconque des revendications 1 à 9,
dans lequel le circuit de courant de queue (450) est configuré pour commuter entre le premier mode et le second mode en réponse à un changement d'un niveau d'un signal de sortie de comparateur émis à travers le nœud de sortie (409) ou du signal de sortie de comparateur retardé.

11. Convertisseur analogique-numérique selon l'une quelconque des revendications précédentes, comprenant en outre :
un convertisseur numérique-analogique (22) comprenant une entrée de commande et une sortie analogique, dans lequel la sortie analogique est couplée électriquement à la première entrée de commande ou à la seconde entrée de commande du comparateur (400) ; et
un circuit de commande auxiliaire (500) connecté à l'entrée de commande du convertisseur numérique-analogique (22) et à l'entrée de commande de courant de queue (459) du circuit de courant de queue (450), dans lequel le circuit de commande auxiliaire (500) est configuré pour fournir un changement synchronisé d'un premier signal de commande numérique appliqué à l'entrée de commande du convertisseur numérique-analogique (22) et du signal de commande de courant de queue appliqué à l'entrée de commande de courant de queue (459).

12. Dispositif d'imagerie à semi-conducteurs, comprenant :
une unité de réseau de pixels (11) comprenant une pluralité de circuits de pixels (11P) agencés sous forme de matrice, les circuits de pixels (11P) étant configurés pour effectuer une conversion photoélectrique ; et
un convertisseur analogique-numérique (14) selon l'une quelconque des revendications précédentes.

13. Système de caméra, comprenant :
un dispositif d'imagerie à semi-conducteurs (230200) selon la revendication précédente ; et un système optique configuré pour former une image de sujet sur le dispositif d'imagerie à semi-conducteurs (23020).
